# FASCICULE DE BREVET EUROPEEN

(11) **EP 0 658 078 B1**
(45) Date de publication et mention de la délivrance du brevet: **07.04.1999**
(21) Numéro de dépôt: 94420343.9
(22) Date de dépôt: 07.12.1994
(51) Int. Cl.: H05K 7/14

(54) **Boîtier d'habillage électronique à dispositif d'immobilisation de circuits**
Elektronisches Gehäuse mit einer Leiterplattenhaltevorrichtung
Electronic casing with circuitry fixation means

(30) Priorité: 07.12.1993 FR 9314893
(43) Date de publication de la demande: 14.06.1995
(73) Titulaire: DIPTAL (société à responsabilité limitée), F-01410 Chezery Forens (FR)
(72) Inventeur: Myallonnier, Alain, F-01410 Lelex (FR); Morim, Pedro, F-01100 Oyonnax (FR); Myallonnier, Olivier, F-01100 Oyonnax (FR)
(74) Mandataire: Poncet, Jean-François

(56) Documents cités:
- DE-U- 7 247 066
- GB-A- 2 139 006

## Description

La présente invention concerne les boîtiers destinés à contenir et à protéger des circuits électroniques pour constituer un ensemble manipulable.

On connaît déjà des boîtiers d'habillage en matière plastique moulée constitués d'un corps de boîtier ouvert et d'un couvercle rapporté permettant de le fermer. Le fond du corps de boîtier comprend des bossages contre lesquels peut venir porter la face inférieure d'une plaque de circuit imprimé. La plaque est tenue en appui contre les bossages par des vis traversant des trous formés dans la plaque et des trous correspondants prévus dans les bossages.

Cette disposition traditionnelle nécessite des opérations fastidieuses de vissage et de dévissage lors du montage ou du démontage de la plaque de circuit imprimé dans le boîtier.

La présence des bossages et des vis réduit la surface utile du circuit imprimé, ou surface permettant la disposition des pistes conductrices et/ou des composants électroniques du circuit imprimé.

En outre, cette disposition augmente le coût de production du boîtier et des éléments permettant le maintien des plaques de circuit imprimé.

On connaît également des boîtiers d'habillage, tels que décrits dans les documents DE-U-7 247 066 ou GB-A-2 139 006, dont les faces intérieures comportent des séries de nervures et rainures permettant l'engagement des bords de cartes électroniques. Dans le cas d'un boîtier en matière plastique moulée, les rainures et nervures intérieures induisent la présence de dépressions visibles sur les faces extérieures du boîtier, qui nuisent considérablement à son aspect.

Le problème proposé par la présente invention est d'assurer l'immobilisation du ou des circuits imprimés à l'intérieur d'un boîtier sans utilisation de vis, tout en permettant le démontage aisé du circuit imprimé, sans empiéter sur la surface utile du circuit imprimé. L'invention vise en outre à améliorer la simplicité et l'efficacité du boîtier d'habillage, en facilitant le montage et le démontage de la plaque de circuit imprimé dans le boîtier, sans que les éléments de maintien de la plaque de circuit imprimé dans le boîtier soient visibles de l'extérieur.

Pour atteindre ces objets ainsi que d'autres, le boîtier d'habillage électronique selon l'invention comprend un corps de boîtier et un couvercle amovible s'adaptant sur le corps de boîtier pour le fermer. Le boîtier comprend en outre des moyens pour maintenir au moins une plaque de circuit imprimé à l'intérieur du boîtier, ces moyens comprenant :
- des premiers moyens d'encastrement dans le corps du boîtier adaptés pour recevoir et retenir une première extrémité de la plaque de circuit imprimé en s'opposant au soulèvement de la plaque de circuit imprimé à l'écart du fond et à sa translation longitudinale dans une direction parallèle à celle de ladite première extrémité,
- une paroi intermédiaire rapportée sensiblement perpendiculaire au fond du corps de boîtier, tenue par des guides latéraux ménagés sur deux faces latérales opposées du corps de boîtier, et munie sur l'une de ses faces de bossages adaptés pour venir porter sur au moins la face supérieure de la plaque de circuit imprimé à ou au voisinage de sa seconde extrémité opposée à ladite première extrémité lorsque la paroi intermédiaire est engagée en position dans le corps de boîtier, la paroi intermédiaire formant également une butée contre laquelle porte le chant de seconde extrémité de plaque de circuit imprimé.

De préférence, la paroi intermédiaire rapportée est retenue en position dans le boîtier par des moyens d'encliquetage ménagés sur lesdites faces latérales opposées du boîtier et sur les chants latéraux correspondants de la paroi intermédiaire.

Selon un mode de réalisation, ces moyens d'encliquetage comprennent des lumières ménagées dans l'épaisseur de feuillures du boîtier prévues pour l'adaptation du couvercle, et des ergots dépassant des chants de la paroi intermédiaire et adaptés pour s'engager dans les lumières lorsque la paroi est en position.

Selon un mode de réalisation avantageux, les premiers moyens d'encastrement comprennent des bossages ménagés sur une face interne de paroi périphérique du boîtier, conformés pour venir en appui sur au moins la face supérieure de la plaque de circuit imprimé lorsque celle-ci est en position dans le boîtier.

En alternative, les premiers moyens d'encastrement comprennent des bossages ménagés sur la face interne d'un élément rapporté dans le corps de boîtier, les bossages étant conformés pour venir en appui sur au moins la face supérieure de la plaque de circuit imprimé lorsque celle-ci est en position dans le corps de boîtier.

D'autres objets, caractéristiques et avantages de la présente invention ressortiront de la description suivante de modes de réalisation particuliers, faite en relation avec les figures jointes, parmi lesquelles:
- la figure 1 est une vue en perspective d'un boîtier d'habillage électronique selon l'invention, contenant une plaque de circuit imprimé et une pile d'alimentation, représenté couvercle ouvert ;
- la figure 2 est une vue de côté en coupe longitudinale du boîtier de la figure 1, couvercle enlevé ;
- la figure 3 est une vue partielle en perspective du boîtier de la figure 1, avec sa paroi intermédiaire soulevée ;
- la figure 4 est une vue en perspective du boîtier de la figure 1, selon une autre orientation de perspective ;
- la figure 5 est une vue en perspective éclatée d'un boîtier d'habillage électronique selon un autre mode de réalisation de l'invention ;
- la figure 6 est une vue partielle en perspective du boîtier de la figure 5 selon une autre orientation ;
- la figure 7 est une vue en perspective éclatée d'un boîtier d'habillage électronique selon un autre mode de réalisation de l'invention.

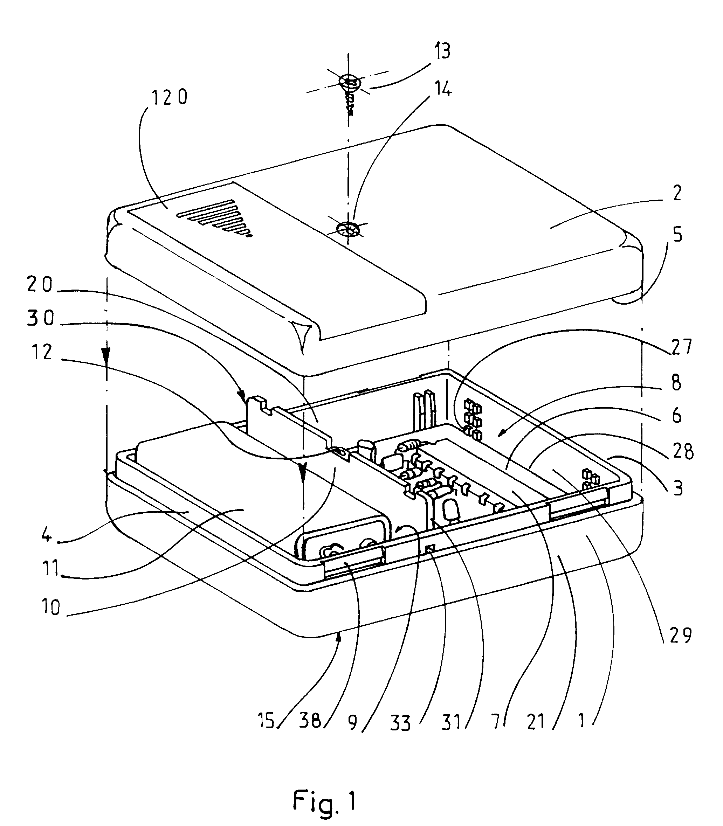

Dans le mode de réalisation représenté sur les figures 1 à 4, le boîtier d'habillage électronique selon l'invention comprend un corps de boîtier 1 généralement parallélépipédique rectangle, ouvert sur le dessus, et un couvercle 2 amovible s'adaptant sur le corps de boîtier 1 pour le fermer. Le bord périphérique supérieur 3 du corps de boîtier 1 comprend une feuillure 4 autour de laquelle vient s'encastrer le bord inférieur 5 du couvercle 2, comme représenté.

Le corps de boîtier 1 contient une plaque de circuit imprimé 6 supportant elle-même des composants électroniques 7. La plaque de circuit imprimé 6 est logée dans un premier compartiment 8 du corps de boîtier 1, séparé d'un second compartiment 9 par une paroi intermédiaire 10. Le second compartiment 9 contient une pile d'alimentation 11 permettant d'alimenter en énergie électrique, par des conducteurs non représentés, les composants électroniques 7 de la plaque de circuit imprimé 6.

Le couvercle 2 comprend une ouverture obturable par un volet coulissant 120 donnant accès au second compartiment 9 lorsque le couvercle 2 est adapté sur le corps de boîtier 1.

La paroi intermédiaire 10 comprend un trou supérieur 12 de fixation pour recevoir et retenir la tige d'une vis 13 traversant elle-même un trou 14 correspondant du couvercle 2. La vis 13 assure la fixation inviolable du couvercle 2 sur le corps de boîtier 1.

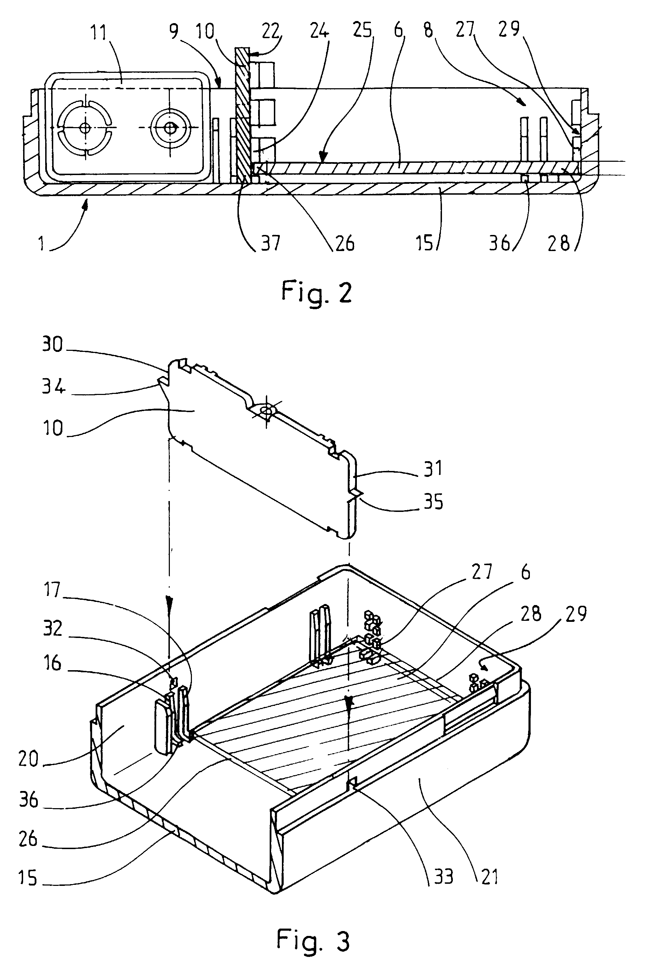

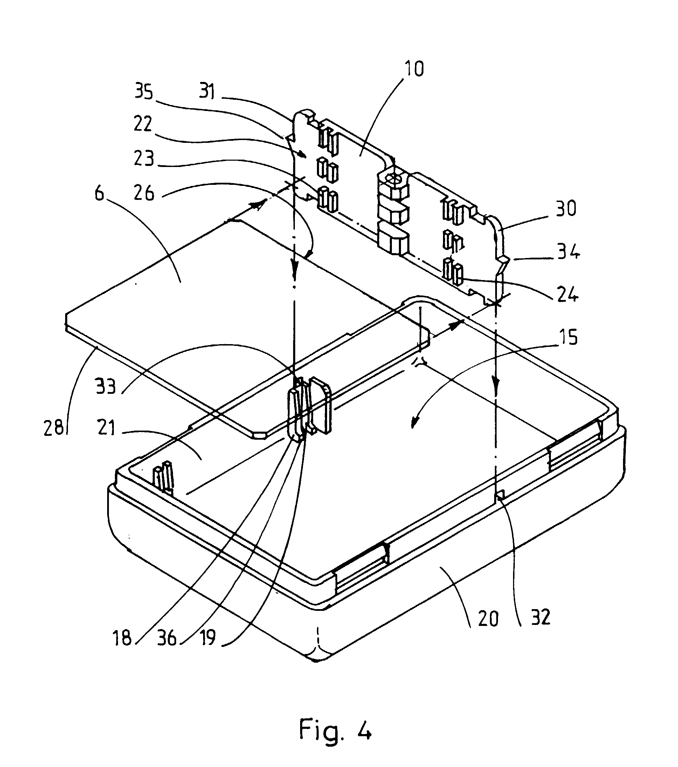

La paroi intermédiaire 10 est une paroi rapportée, sensiblement perpendiculaire au fond 15 du corps de boîtier 1. Elle est tenue par des guides latéraux 16, 17, 18 et 19 représentés sur les figures 3 et 4, ménagés sur deux faces latérales opposées 20 et 21 du corps de boîtier 1.

Sur sa face d'appui 22 orientée vers le premier compartiment 8 contenant la plaque de circuit imprimé 6, la paroi intermédiaire 10 est munie de bossages tels que les bossages 23 et 24, adaptés pour venir porter sur au moins la face supérieure 25 de la plaque de circuit imprimé 6 à ou au voisinage de sa seconde extrémité 26.

Des premiers moyens d'encastrement 27 sont adaptés dans le corps de boîtier 1 pour recevoir et retenir une première extrémité 28 de la plaque de circuit imprimé 6, en s'opposant au soulèvement de la plaque 6 à l'écart du fond 15 et à sa translation longitudinale en direction de ladite première extrémité 28.

Dans le mode de réalisation représenté sur les figures 1 à 4, les premiers moyens d'encastrement 27 comprennent des bossages ménagés sur une face interne 29 de paroi périphérique du corps de boîtier 1. Ces bossages sont conformés pour venir en appui sur au moins la face supérieure 25 de la plaque de circuit imprimé 6 lorsque celle-ci est en position dans le corps de boîtier 1.

La paroi intermédiaire 10 est retenue en position dans le corps de boîtier 1 par des moyens d'encliquetage ménagés entre les faces latérales opposées 20 et 21 du corps de boîtier 1 et les chants latéraux correspondants 30 et 31 de la paroi intermédiaire 10.

Dans le mode de réalisation représenté, les moyens d'encliquetage comprennent des lumières 32 et 33 ménagées dans l'épaisseur des feuillures 4 du corps de boîtier, et des ergots correspondants 34 et 35 dépassant des chants latéraux 30 et 31 de la paroi intermédiaire 10. Les ergots 34 et 35 sont adaptés pour s'engager dans les lumières correspondantes 32 et 33 lorsque la paroi intermédiaire 10 est en position dans le corps de boîtier 1, retenue perpendiculairement au fond 15 du corps de boîtier 1 par les guides latéraux 16-19.

A l'utilisation, pour insérer une carte de circuit imprimé 6 dans le boîtier, on retire préalablement le couvercle 2 et la paroi intermédiaire 10. On insère la carte de circuit imprimé 6 dans le corps de boîtier 1 pour venir loger sa première extrémité 28 sous les bossages constituant les premiers moyens d'encastrement 27. La plaque de circuit imprimé 6 vient alors en appui sur des ergots ou nervures inférieurs 36, par exemple des prolongements inférieurs des guides latéraux 16-19 comme représenté sur les figures 3 et 4. Dans cette position, la plaque de circuit imprimé 6 est sensiblement parallèle au fond 15 du corps de boîtier 1. On vient alors engager la paroi intermédiaire 10, par coulissement vertical dans les guides latéraux 16-19, jusqu'à venir encliqueter les ergots 34 et 35 dans les lumières 32 et 33, pour verrouiller la paroi intermédiaire 10 en position. Le chant inférieur 37 de la plaque intermédiaire 10 est alors en appui sur le fond 15 du corps de boîtier 1, et les bossages 23 et 24 sont en appui contre la face supérieure 25 de la plaque de circuit imprimé 6 sur ou au voisinage de sa seconde extrémité 26 opposée à la première extrémité 28. La paroi intermédiaire 10 forme alors également une butée contre laquelle porte le chant de seconde extrémité 26 de la plaque de circuit imprimé 6. La plaque de circuit imprimé 6 se trouve ainsi tenue au voisinage de ses deux extrémités 28 et 26. On peut incorporer la pile d'alimentation 11 dans le second compartiment 9, et adapter le couvercle 2 qui peut être retenu sur le corps de boîtier 1 par des crochets d'encliquetage 38 ménagés dans la feuillure 4, comme représenté. Si nécessaire, la vis 13 traversant le trou 14 et se vissant dans le trou 12 de la paroi intermédiaire 10 vient compléter la fixation du couvercle 2 sur le corps de boîtier 1.

Dans le mode de réalisation représenté sur ces mêmes figures 1 à 4, le boîtier est adapté pour le maintien de plusieurs cartes de circuit imprimé disposées les unes au-dessus des autres parallèlement au fond 15 du corps de boîtier 1. Pour cela, les premiers moyens d'encastrement 27 comprennent plusieurs séries de bossages disposés sur la face intérieure 29 du corps de boîtier 1, au voisinage respectivement du premier et du second coins formant les extrémités de ladite face intérieure 29, et situées à des distances appropriées du fond 15 du corps de boîtier 1 pour tenir les premiers bords 28 des cartes de circuit imprimé en empêchant leur soulèvement ou leur enfoncement à l'écart de et vers le fond 15. De même, la paroi intermédiaire comprend des séries de bossages tels que les bossages 23 et 24, disposés au voisinage des extrémités de la paroi intermédiaire 10 et selon des écartements appropriés par rapport au fond 15 du corps de boîtier 1 pour tenir les secondes extrémités 26 des circuits imprimés 6 et empêcher leur soulèvement ou leur enfoncement à l'écart de ou vers le fond 15 de corps de boîtier 1.

De préférence, les séries de bossage tels que les bossages 23 et 24 de paroi intermédiaire 10, ainsi que les bossages formant les premiers moyens d'encastrement 27, forment eux-mêmes des nervures verticales constituant des moyens de guidage pour maintenir des plaques de circuit imprimé que l'on disposerait perpendiculairement au fond 15 du corps de boîtier 1, à la place de la plaque de circuit imprimé 6 représentée sur les figures.

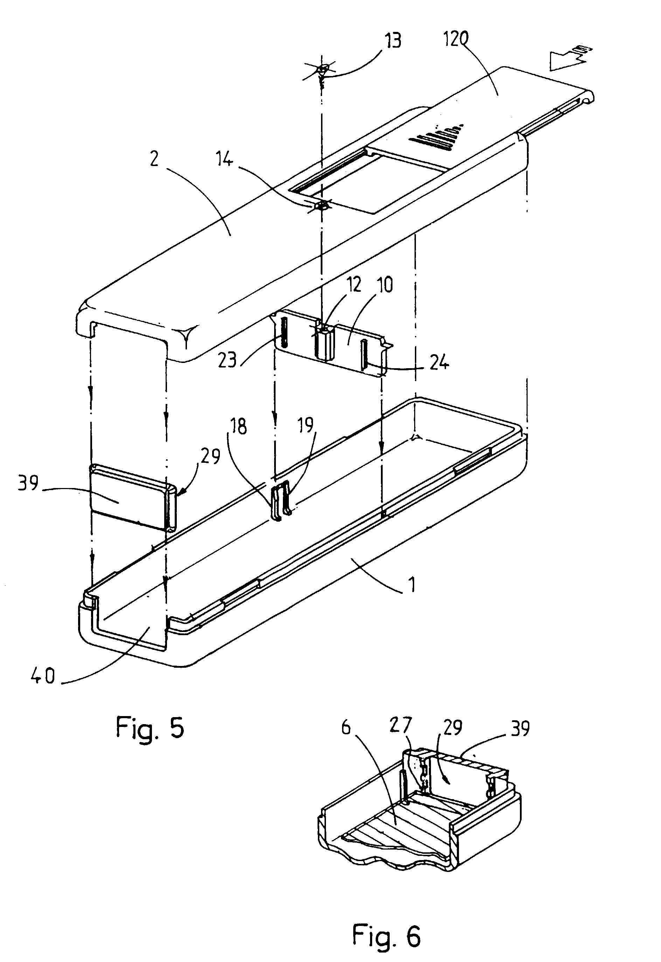

Dans le mode de réalisation représenté sur les figures 5 et 6 les premiers moyens d'encastrement 27 sont ménagés sur la face interne 29 d'une partie rapportée 39 de paroi périphérique de corps de boîtier 1. Cette partie rapportée 39 vient s'adapter par coulissement vertical dans une encoche 40 de la paroi périphérique de corps de boîtier 1, et peut être constituée d'un élément transparent permettant une visualisation d'affichage ou la transmission d'un rayon lumineux dans le spectre visible ou dans le spectre infrarouge. Les autres éléments sont similaires de ceux du mode de réalisation des figures 1 à 4, et portent les mêmes références numériques. On retrouve en particulier le volet coulissant 120 du couvercle 2.

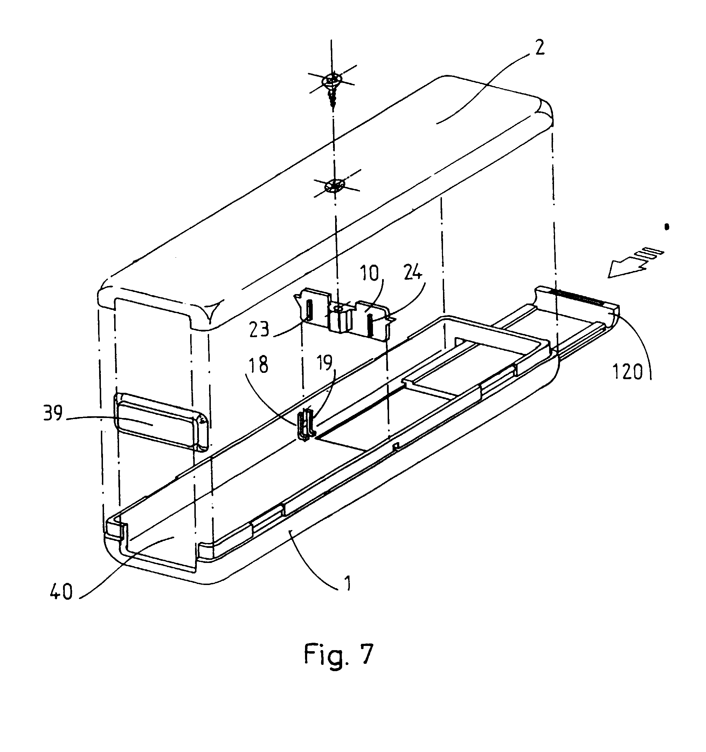

Le mode de réalisation de la figure 7 est similaire de celui de la figure 5, et diffère en ce que le volet coulissant 120 est adapté sur le corps de boîtier 1, et non sur le couvercle 2. Les autres éléments sont inchangés, et portent les mêmes références numériques.

Le corps de boîtier 1, le couvercle 2, la paroi intermédiaire 10 et éventuellement sa partie rapportée 39 peuvent avantageusement être réalisés par moulage de matières plastiques.

La présente invention n'est pas limitée aux modes de réalisation qui ont été explicitement décrits, mais elle en inclut les diverses variantes et généralisations contenues dans le domaine des revendications ci-après.

## Revendications

1. Boîtier d'habillage électronique, comprenant un corps de boîtier (1) et un couvercle (2) amovible s'adaptant sur le corps de boîtier (1) pour le fermer, et comprenant des moyens pour maintenir au moins une plaque de circuit imprimé (6) à l'intérieur du boîtier, caractérisé en ce que les moyens pour maintenir la plaque de circuit imprimé (6) comprennent :
- des premiers moyens d'encastrement (27) dans le corps du boîtier adaptés pour recevoir et retenir une première extrémité (28) de la plaque de circuit imprimé (6) en s'opposant au soulèvement de la plaque de circuit imprimé (6) à l'écart du fond (15) et à sa translation longitudinale dans une direction parallèle à celle de ladite première extrémité (28),
- une paroi intermédiaire (10) rapportée sensiblement perpendiculaire au fond (15) du corps de boîtier (1), tenue par des guides latéraux (16-19) ménagés sur deux faces latérales (20, 21) opposées du corps de boîtier (1), et munie sur l'une de ses faces (22) de bossages (23, 24) adaptés pour venir porter sur au moins la face supérieure (25) de la plaque de circuit imprimé (6) à ou au voisinage de sa seconde extrémité (26) opposée à ladite première extrémité (28) lorsque la paroi intermédiaire (10) est engagée en position dans le corps de boîtier (1), la paroi intermédiaire (10) formant également une butée contre laquelle porte le chant de seconde extrémité (26) de plaque de circuit imprimé (6).

2. Boîtier selon la revendication 1, caractérisé en ce que la paroi intermédiaire (10) rapportée est retenue en position dans le boîtier par des moyens d'encliquetage (32-35) ménagés sur lesdites faces latérales (20, 21) opposées du corps de boîtier (1) et sur les chants latéraux correspondants (30, 31) de la paroi intermédiaire (10).

3. Boîtier selon la revendication 2, caractérisé en ce que les moyens d'encliquetage comprennent :
- des lumières (32, 33) ménagées dans l'épaisseur de feuillures (4) du corps de boîtier (1) prévues pour l'adaptation du couvercle (2),
- des ergots (34, 35) dépassant des chants latéraux (30, 31) de la paroi intermédiaire (10) et adaptés pour s'engager dans les lumières (32, 33) lorsque la paroi intermédiaire (10) est en position.

4. Boîtier selon la revendication 1, caractérisé en ce que les bossages (23, 24) de paroi intermédiaire (10) forment des nervures verticales constituant des moyens de guidage pour maintenir des plaques de circuit imprimé disposées perpendiculairement au fond (15) du corps de boîtier (1).

5. Boîtier selon l'une quelconque des revendications 1 à 4, caractérisé en ce que les premiers moyens d'encastrement (27) comprennent des bossages ménagés sur une face interne (29) de paroi périphérique de corps de boîtier (1), conformés pour venir en appui sur au moins la face supérieure (25) de la plaque de circuit imprimé (6) lorsque celle-ci est en position dans le corps de boîtier (1).

6. Boîtier selon l'une quelconque des revendications 1 à 4, caractérisé en ce que les premiers moyens d'encastrement (27) comprennent des bossages ménagés sur la face interne (29) d'un élément rapporté (39) dans le corps de boîtier (1), conformés pour venir en appui sur au moins la face supérieure (25) de la plaque de circuit imprimé (6) lorsque celle-ci est en position dans le corps de boîtier (1).

7. Boîtier selon la revendication 6, caractérisé en ce que l'élément rapporté (39) forme une partie de la paroi périphérique de corps de boîtier (1).

8. Boîtier selon l'une quelconque des revendications 1 à 7, caractérisé en ce que la paroi intermédiaire (10) comprend un trou de fixation (12) pour recevoir et retenir la tige d'une vis de fixation (13) traversant le couvercle (2) pour la fixation inviolable du couvercle (2).

## Patentansprüche

1. Elektronikgehäuse mit einem Gehäusekörper (1) und einem abnehmbaren Deckel (2), der an den Gehäusekörper (1) angepaßt ist, um ihn zu verschließen, und mit Mitteln zum Halten mindestens einer Leiterplatte (6) im Innern des Gehäuses, dadurch gekennzeichnet, daß die Mittel zum Halten der Leiterplatte (6) folgendes aufweisen:
- erste Einbaumittel (27) im Gehäusekörper, die zum Aufnehmen und Halten eines ersten Endes (28) der Leiterplatte (6) vorgesehen sind und die sich einem Anheben der Leiterplatte (6) vom Boden (15) weg und ihrer Verschiebung in einer Längsrichtung parallel zum ersten Ende (28) wiedersetzen,
- eine Zwischenwand (10), die im wesentlichen senkrecht auf dem Boden (15) des Gehäusekörpers (1) angeordnet und durch seitliche Führungen (16-19) gehalten ist, die an zwei gegenüberliegenden Seitenflächen (20, 21) des Gehäusekörpers (1) angebracht sind,und die an einer ihrer Seiten (22) Erhebungen (23, 24) aufweist, die dazu vorgesehen sind, wenigstens über die Oberseite (25) der Leiterplatte (6) zu greifen, am oder in der Nähe ihres zweiten Endes (26), das dem ersten Ende (28) gegenüberliegt, wenn die Zwischenwand (10) im Gehäusekörper (1) positioniert ist, wobei die Zwischenwand (10) auch einen Anschlag bildet, an dem die Kante des zweiten Endes (26) der Leiterplatte (6) anliegt.

2. Gehäuse nach Anspruch 1, dadurch gekennzeichnet, daß die eingesetzte Zwischenwand (10) durch Einrastmittel (32-35) im Gehäuse in Position gehalten wird, die an den gegenüberliegenden Seitenflächen (20, 21) des Gehäusekörpers (1) und an den zugeordneten seitlichen Kanten (30, 31) der Zwischenwand (10) angeordnet sind.

3. Gehäuse nach Anspruch 2, dadurch gekennzeichnet, daß die Einrastmittel folgendes aufweisen:
- Ausnehmungen (32, 33), die in der Stärke von Falzen (4) des Gehäusekörpers (1) ausgespart sind, zum Anbringen des Deckels (2),
- Vorsprünge (34, 35), die von den seitlichen Kanten (30, 31) der Zwischenwand (10) abstehen und zum Eingreifen in die Ausnehmungen (32, 33) vorgesehen sind, wenn die Zwischenwand (10) positioniert ist.

4. Gehäuse nach Anspruch 1, dadurch gekennzeichnet, daß die Erhebungen (23, 24) der Zwischenwand (10) vertikale Rippen bilden, die Führungsmittel darstellen, zum Halten von Leiterplatten, die senkrecht auf dem Boden (15) des Gehäusekörpers (1) angeordnet sind.

5. Gehäuse nach einem der Ansprüche 1 bis 4, dadurch gekennzeichnet, daß die ersten Einbaumittel (27) Erhebungen aufweisen, die an einer Innenseite (29) der Außenwand des Gehäusekörpers (1) angebracht sind, und dazu vorgesehen sind, wenigstens die Oberseite (25) der Leiterplatte (6) zu halten, wenn diese im Gehäusekörper (1) positioniert ist.

6. Gehäuse nach einem der Ansprüche 1 bis 4, dadurch gekennzeichnet, daß die ersten Einbaumittel (27) Erhebungen aufweisen, die an der Innenseite (29) eines Bauteils (39) angebracht sind, das in den Gehäusekörper (1) eingesetzt ist, welche dazu vorgesehen sind, wenigstens die Oberseite (25) der Leiterplatte (6) zu halten, wenn diese im Gehäusekörper (1) positioniert ist.

7. Gehäuse nach Anspruch 6, dadurch gekennzeichnet, daß das eingesetzte Bauteil (39) einen Teil der Außenwand des Gehäusekörpers (1) bildet.

8. Gehäuse nach einem der Ansprüche 1 bis 7, dadurch gekennzeichnet, daß die Zwischenwand (10) ein Befestigungsloch (12) aufweist zum Aufnehmen und Halten des Schafts einer Befestigungsschraube (13), die den Deckel (2) durchsetzt, zum zerstörungsfreien Befestigen des Deckels (2).

## Claims

1. Electronic packaging case, comprising a case body (1) and a removable lid (2) which fits onto the case body (1) in order to close it, and comprising means for holding at least one printed-circuit board (6) in place inside the case, characterized in that the means for holding the printed-circuit board (6) in place comprise :
- first fitting means (27) in the case body which are suitable for receiving and holding a first end (28) of the printed-circuit board (6) so as to prevent the printed-circuit board (6) from lifting away from the bottom (15) and from moving longitudinally in a direction parallel to that of the said first end (28),
- an added intermediate wall (10) substantially perpendicular to the bottom (15) of the case body (1), retained by lateral guides (16-19) made on two opposed lateral faces (20, 21) of the case body (1), and provided on one of its faces (22) with projections (23, 24) suitable for bearing on at least the upper face (25) of the printed-circuit board (6) at or near its second end (26) opposite the said first end (28) when the intermediate wall (10) is put into position in the case body (1), the intermediate wall (10) also forming a stop against which the edge of the second end (26) of the printed-circuit board (6) bears.

2. Case according to claim 1, characterized in that the added intermediate wall (10) is held in position in the case by snap-in means (32-35) made on the said opposed lateral faces (20, 21) of the case body (1) and on the corresponding lateral edges (30, 31) of the intermediate wall (10).

3. Case according to claim 2, characterized in that the snap-in means comprise :
- slots (32, 33) made in the thickness of rabbets (4) of the case body (1) which are provided for fitting the lid (2),
- catches (34, 35) projecting from the lateral edges (30, 31) of the intermediate wall (10) and suitable for engaging in the slots (32, 33) when the intermediate wall (10) is in position.

4. Case according to claim 1, characterized in that the projections (23, 24) of the intermediate wall (10) form vertical ribs constituting guiding means for holding printed-circuit boards, arranged so as to be perpendicular to the bottom (15) of the case body (1).

5. Case according to any one of claims 1 to 4, characterized in that the first fitting means (27) comprise projections made on an internal face (29) of the peripheral wall of the case body (1), shaped so as to bear on at least the upper face (25) of the printed-circuit board (6) when the latter is in position in the case body (1).

6. Case according to any one of claims 1 to 4, characterized in that the first fitting means (27) comprise projections made on the internal face (29) of an added element (39) in the case body (1), shaped so as to bear on at least the upper face (25) of the printed-circuit board (6) when the latter is in position in the case body (1).

7. Case according to claim 6, characterized in that the added element (39) forms part of the peripheral wall of the case body (1).

8. Case according to any one of claims 1 to 7, characterized in that the intermediate wall (10) comprises a fixing hole (12) for receiving and holding the shank of a fixing screw (13) which passes through the lid (2) in order to fix the lid (2) in a tamperproof manner.
